# EUROPÄISCHE PATENTSCHRIFT

(11) **EP 1 254 482 B1**
(45) Veröffentlichungstag und Bekanntmachung des Hinweises auf die Patenterteilung: **04.05.2011**
(21) Anmeldenummer: 01927654.2
(22) Anmeldetag: 07.02.2001
(51) Int. Cl.: H01L 29/732, H01L 21/331

(54) **Verfahren zur Herstellung eines Bipolartransistors**
Method of manufacturing a bipolar transistor
Procédé de fabrication d'un transistor bipolaire

(30) Priorität: 08.02.2000 DE 10005442
(43) Veröffentlichungstag der Anmeldung: 06.11.2002
(73) Patentinhaber: Infineon Technologies AG, 85579 Neubiberg (DE)
(72) Erfinder: FRANOSCH, Martin, 81739 München (DE); SCHÄFER, Herbert, 85635 Höhenkirchen-Siegertsbrunn (DE); MEISTER, Thomas, 82024 Taufkirchen (DE); STENGL, Reinhard, 86391 Stadtbergen (DE)
(74) Vertreter: Ginzel, Christian
(86) Internationale Anmeldenummer: PCT/EP2001/001324
(87) Internationale Veröffentlichungsnummer: WO 2001/059845

(56) Entgegenhaltungen:
- EP-A- 0 476 412
- EP-A- 0 535 350
- EP-A- 0 600 276
- EP-A- 0 768 716
- WO-A-97/37377
- US-A- 5 296 391
- SATO F: "A SELF-ALIGNED SELECTIVE MBE TECHNOLOGY FOR HIGH-PERFORMANCE BIPOLAR TRANSISTORS" INTERNATIONAL ELECTRON DEVICES MEETING. SAN FRANCISCO, DEC. 9 - 12, 1990, NEW YORK, IEEE, US, 9. Dezember 1990 (1990-12-09), Seiten 607-610, XP000279609

## Beschreibung

Die vorliegende Erfindung betrifft ein Verfahren zum Herstellen eines Bipolartransistors.

Bipolartransistoren sind im allgemeinen aus zwei nahe beieinander liegenden pn-Ubergängen in einem Halbleiterkristall aufgebaut. Dabei werden entweder zwei n-dotierte Gebiete durch ein p-dotiertes Gebiet voneinander getrennt (sogenannte npn-Transistoren) oder zwei p-dotierte durch ein n-dotiertes Gebiet (pnp-Transistoren). Die drei unterschiedlich dotierten Gebiete werden als Emitter (E), Basis (B) und Kollektor (C) bezeichnet. Bipolartransistoren sind bereits seit langem bekannt und werden auf vielfältige Art und Weise eingesetzt. Dabei unterscheidet man zwischen sogenannten Einzeltransistoren, die für die Montage auf Leiterplatten oder dergleichen gedacht und in einem eigenen Gehäuse untergebracht sind, und sogenannten integrierten Transistoren, die zusammen mit weiteren Halbleiterbauelementen auf einem gemeinsamen Halbleiterträger, der in der Regel als Substrat bezeichnet wird, hergestellt werden.

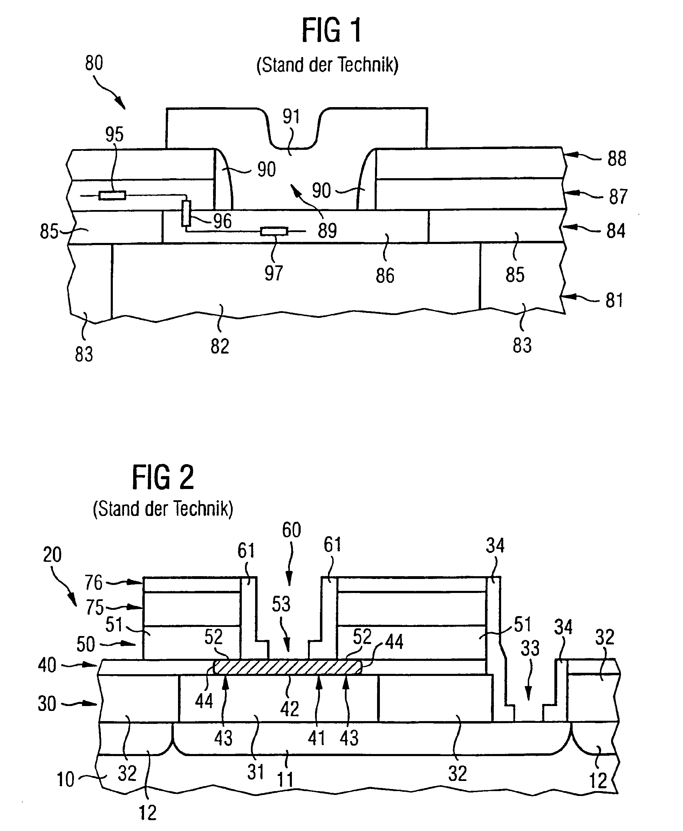

Bekannte Bipolartransistoren haben den Nachteil, daß sie einen relativ großen Ubergangswiderstand aufweisen. Dies ergibt sich beispielsweise aus Figur 1, in der ein aus dem Stand der Technik bekannter Bipolartransistor in vereinfachter Weise dargestellt ist.

Der Bipolartransistor gemäß Figur 1 weist eine Basis mit einem Basisbahnwiderstand auf. Weiterhin ist eine Zuleitung vorgesehen, die in einer Ubergangszone in die monokristalline Basis übergeht. Der Übergangswiderstand dieser übergangszone geht in den Gesamt-Basiswiderstand des Transistors ein. Für verschiedene Transistoreigenschaften, beispielsweise für hohe Schaltgeschwindigkeiten, ist es von Vorteil, wenn der gesamte Basiswiderstand so klein wie möglich ist. Der Gesamt-Basiswiderstand setzt sich gemäß der in Figur 1 dargestellten Darstellungsweise aus drei Komponenten zusammen, nämlich dem Basiszuleitungswiderstand, dem Übergangswiderstand (auch Basisanschlußwiderstand genannt) sowie dem Basisbahnwiderstand der Basis. Zur Berechnung des Gesamt-Basiswiderstands des Transistors müssen die drei Einzelwiderstände addiert werden. Bei dem Übergangswiderstand handelt es sich um einen verringerbaren Anteil, der üblicherweise mindestens 15 % des Gesamt-Basiswiderstands ausmacht.

Es besteht daher das Bedürfnis, Bipolartransistoren zu schaffen, bei denen der Übergangswiderstand zwischen der Basis und der Zuleitung minimiert ist.

Ein bekannter Bipolartransistor ist beispielsweise in der von der Anmelderin ebenfalls eingereichten EP-A-0 535 350 B1 offenbart. Diese Druckschrift, von der die vorliegende Erfindung ausgeht, beschreibt ein Verfahren zur Herstellung eines seitlich begrenzten, einkristallinen Gebiets in einem Bipolartransistor. Dieser Bipolartransistor ist schematisch in Figur 2 dargestellt. Er weist eine erste, auf einem Substrat befindliche, Schicht auf, in der ein Kollektor vorgesehen ist. Auf der ersten Schicht befindet sich eine zweite Schicht, die eine Basisausnehmung aufweist, in der sich eine Basis befindet, wobei die Basis oberhalb des Kollektors vorgesehen ist. Weiterhin ist wenigstens eine dritte Schicht vorgesehen, die auf der zweiten Schicht vorgesehen ist, und die eine Zuleitung für die Basis aufweist. Dabei steht die Zuleitung in einem Übergangsbereich mit der Basis in direktem Kontakt. Die dritte Schicht weist ebenfalls eine Emitterausnehmung auf, die oberhalb von der Basis vorgesehen ist und in der sich ein Emitter befindet. Der Übergangsbereich zwischen der Basis und der Zuleitung wird durch eine Unterätzung der zweiten Schicht, bei der es sich beispielsweise um eine TEOS-Schicht handeln kann, festgelegt. Dabei befindet sich die Basis, beziehungsweise das Basismaterial, nicht nur in der eigentlichen Basisausnehmung, sondern auch zumindest bereichsweise im Bereich der Unterätzung.

Der Widerstand des Übergangsbereichs wird während der Herstellung der Basis, beispielsweise der epitaktischen Basisabscheidung, durch die Dotierstoff-Umverteilung und die Umverteilung des Zuleitungsmaterials eingestellt. Eine nachträgliche Wärmebehandlung, beispielsweise ein Tempervorgang, zur Erniedrigung des Übergangswiderstands, ist wegen des begrenzten thermischen Budgets im Basisdotierprofil jedoch nur in begrenztem Umfang möglich.

Aus dem Aufsatz "Sub-20psec ECL Circuits with 50GHz fmax Self-aligned SiGe HBTs" von Sato et al, erschienen in IEEE 1992, IEDM 92, Seiten 397 bis 400 ist bekannt, den Basiswiderstand eines Bipolartransistors zu reduzieren, indem die Ausdiffusion aus einem borhaltigen Spacer-Element verwendet wird.

Eine andere Lösung ist in dem Aufsatz "A7.7-ps CML Using Selective-Epitaxial SiGe HBTs" von Ohue et al, IEEE 1998, Seiten 97 bis 100 angegeben. Gemäß diesem Aufsatz wird eine zusätzliche Schicht aus undotiertem Polysilizium auf der Höhe der selektiv abgeschiedenen Basis eingeführt. Diese Schicht dient als Siliziumquelle während des sogenannten Prebakes und während der Abscheidung. Sie verhindert damit das Entstehen von Lunkern im Bereich der Unterätzung und soll dadurch den Anschlußwiderstand verringern.

Aus EP 0 476 412 ist ein Verfahren zur Herstellung eines Bipolartransistors bekannt, bei dem in einem SiO₂/Si₃N₄/SiO₂-Schichtenstapel, der eine Kollektorschicht bedeckt, eine Öffnung eingebracht wird, in welcher später die Basis und der Emitter des Bipolartransistors ausgebildet werden. Dazu wird zunächst selektiv eine Siliziumschicht auf die Kollektorschicht aufgebracht. Dann wird auf diese Siliziumschicht selektiv eine Basisschicht abgeschieden. Ein Hohlraum zwischen der Basisschicht und einer Polysiliziumzuleitung, welche die Öffnung teilweise überragt, wird dann mit Polysilizium aufgefüllt, um einen Basisanschluß zu bilden.

EP 0 768 716 beschreibt ein Verfahren zur Herstellung eines Bipolartransistors. Dabei wird dort ebenfalls ein SiO₂/si₃N₄/SiO₂-Schichtenstapel auf einer Kollektorschicht verwendet. Allerdings wird zunächst lediglich die obere SiO₂-schicht geöffnet und bis teilweise unter eine Polysiliziumzuleitung zur Bildung einer Unterätzung entfernt. Diese Unterätzung wird dann vollständig mit Polysilizium zur Bildung eines Basisanschlußes aufgefüllt. Dann werden die verbliebenen Si₃N₄- und SiO₂-Schichte geöffnet, wobei die Öffnung eine möglichst kleine Fläche einnehmen soll, damit die darin nachfolgend auszubildende Basis eine möglichst geringe Fläche zur Kollektorschicht aufweist. Dadurch soll die Basis-Kollektor-Kapazität verringert werden.

US 5 296 391 beschreibt ein Verfahren zur Herstellung eines Bipolartransistors, bei dem die Basis sowie ein Basisanschlussgebiet gleichzeitig durch Epitaxie hergestellt werden. Ziel dieses Verfahrens ist es, eine möglichst dünne Basis für Hochfrequenzbauelemente zu erzeugen.

WO 97/37377 A offenbart ein Verfahren zur Herstellung eines Bipolartransistors, bei dem die Basis sowie ein Basisanschlussgebiet gleichzeitig durch Gasphasenabscheidung hergestellt werden.

Ausgehend vom genannten Stand der Technik liegt der vorliegenden Erfindung die Aufgabe zu Grunde, ein verbessertes Verfahren bereitzustellen, mit dem ein Bipolartransistor hergestellt werden kann.

Diese Aufgabe wird durch ein Verfahren nach Anspruch 1 gelöst.

Durch einen nach einem erfindungsgemäßen Verfahren hergestellten Bipolartransistor wird es möglich, den Übergangswiderstand - und damit den Gesamt-Basiswiderstand - zu reduzieren.

Ein grundlegendes Merkmal der vorliegenden Erfindung besteht darin, daß eine zusätzliche Schicht, nämlich die Zwischenschicht, eingeführt wird. Diese Schicht ist selektiv ätzbar zur zweiten Schicht ausgebildet, so daß sie während der Unterätzung in der zweiten Schicht, das heißt zwischen der ersten und dritten Schicht, nicht entfernt wird. Dadurch werden die Herstellungsbedingungen für den Basisanschlußbereich, der sich zwischen der Zuleitung für die Basis und der Basis selbst befindet, und der damit den Übergangswiderstand erzeugt, frei wählbar. Der Basisanschlußbereich kann unabhängig von anderen Herstellungsbedingungen, beispielsweise den Basis-Abscheidebedingungen, gezielt so eingestellt werden, daß er einen möglichst geringen Übergangswiderstand erzeugt. Wie dies auf vorteilhafte Weise geschehen kann, wird im weiteren Verlauf der Beschreibung näher erläutert.

Zu den Vorteilen, Wirkungen, Effekten sowie der Funktionsweise des nach einem erfindungsgemäßen Verfahren hergestellten Biopolartransistors wird ebenfalls auf die nachstehenden Ausführungen zum erfindungsgemäßen Verfahren vollinhaltlich Bezug genommen und hiermit verweisen. Vorzugsweise kann die Zwischenschicht als Nitridschicht, insbesondere als CVD-Nitridschicht, ausgebildet sein. Nitrid wird bei der Herstellung des Bipolartransistors an anderen Stellen ohnehin eingesetzt, so daß bei der Erzeugung derartiger Nitridschichten keine zusätzlichen, neuen Prozeßkomponenten, wie beispielsweise Abscheidungsanlagen oder dergleichen, eingeführt werden müssen. Die Nitridzwischenschicht ist besonders gut selektiv ätzbar zu sogenannten TEOS-Materialien, aus denen die zweite Schicht vorteilhaft hergestellt ist. Besonders vorteilhaft kann die Nitridzwischenschicht mittels eines CVD-Verfahrens hergestellt werden. Bei CVD-Verfahren handelt es sich um Verfahren zur Gasphasenabscheidung, bei denen ausgewählte Gase über ein aufgeheiztes Substrat geleitet werden, auf dem die gewünschte Schicht abgeschieden werden soll. Auf der heißen Substratoberfläche kommt es zu einer Reaktion der Prozeßgase, so daß als Reaktionsprodukte die gewünschte Schicht sowie Gase entstehen, die aus dem Reaktor wieder abgeführt werden.

Bevorzugt kann die zweite Schicht als TEOS-Schicht ausgebildet sein, wobei die Zwischenschicht selektiv ätzbar zur TEOS-Schicht (Tetra-Ethyl-Ortho-Silicate) ausgebildet ist.

Vorteilhaft kann der Basisanschlußbereich selektiv abgeschieden sein. Auf Grund der Tatsache, daß der Basisanschlußbereich unabhängig von anderen Herstellungsbedingungen, beispielsweise der Basisabscheidung, ermöglicht wird, können die Prozeßparameter bei der Herstellung des Basisanschlußbereichs derart eingestellt werden, daß der Übergangswiderstand möglichst gering wird. Beispielsweise kann bei der selektiven Abscheidung des Basisanschlußbereichs die Temperatur und die Dotierung erhöht werden. Dies wird in Verbindung mit dem erfindungsgemäßen Verfahren näher erläutert.

Vorzugsweise kann der Basisanschlußbereich im Übergangsbereich zwischen Zuleitung und Basis in den Bereich der Unterätzung "herausgewachsen" werden oder sein. Als "Herauswachsen" kann im Lichte der vorliegenden Erfindung beispielsweise verstanden werden, daß die Zuleitung für die Basis aus der dafür vorgesehenen dritten Schicht in den Bereich der Unterätzung innerhalb der zweiten Schicht hinein verlängert wird. Der Basisanschlußbereich wird also unter dem durch die dritte Schicht gebildeten Überhang gebildet, in dem er beispielsweise auf derjenigen Oberfläche der Zuleitung, die in direktem Kontakt mit dem Bereich der Unterätzung steht, aufgebracht beziehungsweise abgeschieden wird.

Vorteilhaft kann der Basisanschlußbereich aus Polysilizium gebildet sein. Damit ist der Basisanschlußbereich beispielsweise als sogenannter p+-Anschluß ausgebildet, bei dem jedoch das Wachstum durch geeignete Abscheidebedingungen, wie Abscheidetemperatur oder dergleichen, eingestellt und, sofern gewünscht, die Dotierung erhöht werden kann.

Gemäß der Erfindung steht der Basisanschlußbereich nicht in direktem Kontakt mit der Zwischenschicht. Das bedeutet, daß der Basisanschlußbereich während seiner Herstellung im Übergangsbereich zwischen Zuleitung und späterer Basis derart auf der der Unterätzung zugewandten Oberfläche der Zuleitung aufgebracht beziehungsweise abgeschieden wird, daß dieser in seiner Dicke nicht die Zwischenschicht erreicht. Zwischen dem Basisanschlußbereich und der Zwischenschicht verbleibt somit ein Hohlraum, in dem in einem späteren Arbeitsschritt die Basis ausgebildet werden kann.

Vorzugsweise kann die Zwischenschicht aus einem Material gebildet sein, das mit Phosphorsäure entfernbar ist. In diesem Fall ist die Zwischenschicht vorteilhaft als Nitridschicht ausgebildet.

Die Zwischenschicht kann beispielsweise eine Dicke von gröβer/gleich 4nm aufweisen. Insbesondere, wenn die Zwischenschicht als Nitridschicht ausgebildet ist, würden dünnere Schichten Löcher aufweisen, die beispielsweise keine selektive Epitaxie-Abscheidung zulassen.

In weiterer Ausgestaltung kann in der Emitterausnehmung zwischen Emitter und Zuleitung für die Basis wenigstens ein Spacer-Element vorgesehen sein. Unter Spacer (Abstandsstück) versteht man im allgemeinen eine Struktur, die sich entlang einer Stufe ausbildet und die im vorliegenden Fall beispielsweise dazu dienen kann, den in der Emitterausnehmung vorgesehenen Emitter gegen angrenzende Schichten, beispielsweise die dritte Schicht, zu isolieren. Der Spacer kann beispielsweise aus Nitrid gebildet sein. Er kann vorzugsweise L-Form aufweisen.

Vorzugsweise kann die Zwischenschicht eine Dicke aufweisen, die geringer als die halbe Breite des vorstehend beschriebenen Spacer-Elements ist. Natürlich sind auch Dicken der Zwischenschicht denkbar, die in anderem Verhältnis zur Breite des Spacer-Elements stehen. Wichtig ist lediglich, daß die Zwischenschicht wesentlich dünner als die gesamte Breite des Spacer-Elements ist, da dieser, wenn er in Nitrid ausgeführt ist, beim Entfernen der Nitridzwischenschicht im unteren Bereich ebenfalls gedünnt wird.

Für die Praxis ergibt sich ein vorteilhaftes Prozeßfenster für die Dicke der Zwischenschicht im Bereich zwischen 5 nm und der halben Breite des Spacer-Elements.

Es ist selbstverständlich, daß der Bipolartransistor neben den vorstehend beschriebenen Schichten und Elementen auch weitere Schichten und zusätzliche Elemente aufweisen kann.

Die einzelnen Schichten und Elemente des Bipolartransistors können auf aus dem Stand der Technik bekannte Weisen hergestellt und strukturiert werden. Grundsätzlich werden Bipolartransistoren unter Verwendung verschiedener Techniken, wie beispielsweise der Schichttechnik, der Lithographietechnik, der Ätztechnik und der Dotiertechnik hergestellt.

Mit Hilfe der Schichtechnik können verschiedene Schichten auf einem Substrat aufgebracht werden, die üblicherweise strukturiert werden, was bedeutet, daß sie im Endeffekt nur bereichsweise stehenbleiben. Die wichtigsten Verfahren zur Erzeugung von Schichten im Bereich der Halbleiterindustrie sind das CVD-Verfahren (Chemical Vapor Deposition), die thermische Oxidation, das Sputtern und die Schleuderbeschichtung. Ein weiteres vorteilhaftes Verfahren sieht eine Schichterzeugung mittels Ionenimplantation vor.

Bei einigen für den Bipolartransistor erforderlichen Schichten handelt es sich beispielsweise um sogenannte Epitaxieschichten. Unter Epitaxie versteht man das monokristalline Aufwachsen einer Schicht auf einem monokristallinen Substrat. Bei dem Bipolartransistor kann beispielsweise die Basis als Epitaxieschicht ausgebildet sein.

Die einzelnen Schichten müssen nach ihrer Herstellung üblicherweise in eine Vielzahl von einzelnen Bereichen, beispielsweise Leiterbahnen oder dergleichen, unterteilt werden. Diese Strukturierung kann beispielsweise mittels der Lithographietechnik erfolgen. Ein wesentliches Merkmal dieser Technik besteht darin, daß eine strahlungsempfindliche Resistschicht in den gewünschten Bereichen derart bestrahlt wird, daß in einem geeigneten Entwickler die bestrahlten, beziehungsweise unbestrahlten, Bereiche entfernt werden können. Dadurch entsteht eine Maske für einen darauf folgenden Prozeßschritt, beispielsweise ein Ätzverfahren. Nach Beendigung des darauf folgenden Prozeßschritts wird die Maske wieder abgelöst.

Mit Hilfe eines Ätzverfahrens -beispielsweise eines Naßätzverfahrens- können einzelne Schichten entweder ganzflächig entfernt oder lithographisch erzeugte Maskenmuster in eine darunter liegende Schicht übertragen werden.

Mit Hilfe der Dotiertechnik können einzelne Dotieratome gezielt in Strukturen eindiffundiert werden, wodurch sich deren Eigenschaften verändern können. Beispielsweise kann durch eine geeignete Dotierung des Basisanschlußbereichs erreicht werden, daß der Übergangswiderstand zwischen Zuleitung und Basis reduziert wird. Als geeignete Dotieratome kommen beispielsweise für p-dotierte Bereiche Bor sowie für n-dotierte Bereiche Arsen, Phosphor und Antimon zum Einsatz.

Die vorliegende Erfindung ist nicht auf bestimmte Prozesse oder Verfahrensabläufe zur Herstellung und Strukturierung der einzelnen Schichten und Elemente beschränkt. Ein Beispiel für die Herstellung einzelner Schichten sowie Strukturen in einem Bipolartransistor ist beispielsweise in der EP-A-0 535 350 beschrieben, deren Offenbarungsgehalt insoweit in die Beschreibung der vorliegenden Erfindung miteinbezogen wird.

Gemäß einem ersten Aspekt der vorliegenden Erfindung wird ein Verfahren zum Herstellen eines Bipolartransistors, insbesondere eines wie vorstehend beschriebenen erfindungsgemäßen Bipolartransistors, bereitgestellt, das die Merkmale des unabhängigen Patentanspruchs 12 aufweist. Dieses Verfahren ist somit durch die folgenden Schritte gekennzeichnet:

Zunächst wird auf einem Substrat eine erste Schicht erzeugt, in der ein Kollektor gebildet wird. Der Kollektor, beispielsweise ein n-Kollektor, kann in Boxisolation ausgebildet sein, was bedeutet, daß er von Isolationselementen, die beispielsweise aus TEOS-Material bestehen, flankiert ist. In dem Substrat kann eine vergrabene Schicht, beispielsweise eine sogenannte n+-Buried-Layer, vorgesehen sein, die von Kanalstoppern, beispielsweise p+-Kanalstoppern, begrenzt ist.

In einem nächsten Schritt wird auf der ersten Schicht eine Zwischenschicht aufgebracht Diese Zwischenschicht kann in der wie im Hinblick auf den nach einem erfindungsgemäßen Verfahren hergestellten Bipolartransistor beschriebenen Weise ausgebildet werden und hat die dort beschriebene Funktion.

Anschließend wird auf der Zwischenschicht eine zweite Schicht aufgebracht, wobei die Zwischenschicht aus einem Material besteht, das selektiv ätzbar zum Material der zweiten Schicht ist. Wenn die Zwischenschicht beispielsweise als Nitridschicht und die zweite Schicht beispielsweise als TEOS-Schicht ausgebildet ist, kann durch die selektive Atzbarkeit der Zwischenschicht erreicht werden, daß diese während einer späteren Unterätzung der zweiten Schicht nicht entfernt wird. Im weiteren Verlauf des Verfahrens wird auf der zweiten Schicht eine dritte Schicht gebildet, die so ausgestaltet wird, daß sie eine Zuleitung für eine Basis bildet. Die Zuleitung wird durch entsprechende Strukturierung und Dotierung erzeugt. Diese Schicht kann beispielsweise aus Polysilizium (p+-Material) gebildet sein.

Anschließend werden die zweite und dritte Schicht derart bearbeitet, daß in der zweiten Schicht eine Basisausnehmung für eine Basis und in der dritten Schicht eine Emitterausnehmung für einen Emitter erzeugt wird, wobei die Basisausnehmung oberhalb des Kollektors und die Ausnehmung oberhalb der Basisausnehmung ausgebildet ist. Diese Ausnehmungen können durch geeignete Herstellverfahren und Prozeßschritte, wie sie weiter oben in allgemeiner Weise skizziert wurden, erzeugt werden.

Anschließend wird in der zweiten Schicht im Anschluß an die Basisausnehmung zwischen erster und dritter Schicht eine Unterätzung gebildet, wobei die Zwischenschicht auf Grund ihres zur zweiten Schicht selektiv ätzbaren Materials nicht entfernt wird.

In einem zwischen der Zuleitung und der Unterätzung entstehenden übergangsbereich wird ein mit der Zuleitung in Kontakt stehender Basisanschlußbereich erzeugt, der zumindest teilweise den Bereich der Unterätzung ausfüllt. Auf Grund der Zwischenschicht können dabei die Bedingungen für die Herstellung des Basisanschlußbereichs, beispielsweise entsprechende Abscheidebedingungen, frei gewählt werden, wobei die Herstellung des Basisanschlußbereichs unabhängig von anderen Herstellungsbedingungen, beispielsweise den Basis-Abscheidebedingungen, hergestellt werden kann.

Danach wird derjenige Kontaktbereich der Zwischenschicht, der in der Unterätzung nicht mit Material des Basisanschlußbereichs bedeckt ist und der weiterhin mit der Basisausnehmung in direktem Kontakt steht, entfernt.

Anschließend wird in der Basisausnehmung sowie demjenigen Bereich der Unterätzung, der nicht mit Material des Basisanschlußbereichs ausgefüllt ist, eine Basis gebildet.

Danach wird oberhalb der Basis ein Emitter gebildet.

Die einzelnen Schichten des Bipolartransistors, beziehungsweise deren Strukturierung, kann nach einem der wie vorstehend und in allgemeiner Weise skizzierten Verfahren erfolgen. Die Erfindung ist nicht auf die Verwendung bestimmter Verfahren zur Herstellung bestimmter Schichten beschränkt. Vielmehr ergibt sich der Einsatz des jeweils geeigneten Verfahrens, beziehungsweise Prozeßschritts, aus den Herstellungsbedingungen für den Bipolartransistor. Ein Beispiel zur Herstellung eines solches Bipolartransistors, insbesondere die Abfolge verschiedener Schichtherstellungs-, Lithographie-, Atz- und Dotierschritte ist exemplarisch in der EP-A-0 535 350 beschrieben, deren Offenbarungsgehalt an dieser Stelle insoweit in die Beschreibung der vorliegenden Erfindung mit einbezogen wird. Zu den Vorteilen, Wirkungen, Effekten sowie der Funktionsweise des erfindungsgemäßen Verfahrens wird ebenfalls auf die vorstehenden Ausführungen zu dem nach einem erfindungsgemäßen Verfahren hergestellten Bipolartransistor vollinhaltlich Bezug genommen und hiermit verweisen.

Vorteilhafte Ausführungsformen des erfindungsgemäßen Verfahrens ergeben sich aus den Unteransprüchen.

Vorzugsweise kann der Basisanschlußbereich selektiv abgeschieden werden.

Der Basisanschlußbereich kann im Übergangsbereich zwischen der Zuleitung und der Basis in der Unterätzung "herausgewachsen" werden.

Dabei wird der Basisanschlußbereich derart erzeugt, daß die Zwischenschicht nicht mit Basisanschlußbereichs-Material bedeckt ist.

Vorteilhaft kann der Basisanschlußbereich unabhängig von den Bedingungen zur Herstellung der Basis erzeugt werden. So ist es beispielsweise möglich, daß zur Herstellung des Basisanschlußbereichs die Temperatur und die Dotierung erhöht werden.

Vorzugsweise kann der Basisanschlußbereich bei erhöhten Temperaturen von ≥ 800 °C erzeugt werden.

Durch die Tatsache, daß die Dotierung des Basisanschlußbereichs frei und unabhängig von der aktiven Basis eingestellt wird oder frei eingestellt werden kann, kann der im Basisanschlußbereich herrschende Übergangswiderstand gezielt reduziert werden. Die Dotierung des Basisanschlußbereichs kann mittels der weiter oben in allgemeiner Weise skizzierten Dotiertechnik erfolgen.

Vorzugsweise kann die Zwischenschicht aus Nitrid gebildet werden. Diese Nitridschicht kann selektiv zur zweiten Schicht, beispielsweise einer TEOS-Schicht, mit Phosphorsäure entfernt werden. Danach kann die Herstellung der Basis, beispielsweise mittels einer selektiven Basisabscheidung, erfolgen.

Vorzugsweise kann in der Emitterausnehmung wenigstens ein Spacer-Element ausgebildet werden, das die Funktion eines Isolators übernimmt. Die Zwischenschicht kann vorzugsweise mit einer Dicke von ≥ 4 nm und ≤ der halben Breite des Spacer-Elements gebildet werden.

Die Erfindung wird nun an Hand von Ausführungsbeispielen unter Bezugnahme auf die beiliegende Zeichnung näher erläutert. Es zeigen:
- Figur 1: eine verallgemeinerte, schematische Querschnittsan- sicht eines aus dem Stand der Technik bekannten Bipo- lartransistors;
- Figur 2: eine schematische Querschnittsansicht eines weiteren aus dem Stand der Technik bekannten Bipolartransi- stors;
- Figur 3: eine schematische Querschnittsansicht eines Bipolartransistors zu einem bestimmten Zeitpunkt seines erfindungsgemäßen Herstellungsprozesses;
- Figur 4: eine vergrößerte Ansicht des in Figur 3 dargestellten Details A zu einem im Vergleich zu Figur 3 späteren Zeitpunkt des Bipolar- transistor-Herstellungsprozesses; und
- Figur 5: eine weitere vergrößerte Ansicht des in Figur 3 dar- gestellten Details A zu einem im Vergleich zu Figur 4 späteren Stadium des Bipolartransistor-Herstellungs- prozesses.

In Figur 1 ist zunächst in stark schematisierter Form ein aus dem Stand der Technik bekannter Bipolartransistor 80 dargestellt, aus dem die Berechnung des Gesamt-Basiswiderstands ersichtlich wird. Der Bipolartransistor 80 weist zunächst eine erste Schicht 81 auf, in der ein Kollektor 82, der von Isolationselementen 83 flankiert ist, ausgebildet ist.

Auf der ersten Schicht 81 ist eine zweite Schicht 84 vorgesehen, die eine von einem Dielektrikum 85 umgebene Basis 86 aufweist. Die Basis 86 ist oberhalb von dem Kollektor 82 vorgesehen. Oberhalb der zweiten Schicht 84 ist eine dritte Schicht 87 sowie eine darauf befindliche vierte Schicht 88 vorgesehen. Die dritte Schicht 87 ist beispielsweise aus Polysilizium gebildet und stellt eine Zuleitung für die Basis 86 dar. Bei der vierten Schicht 88 handelt es sich wiederum um eine Dielektrikumsschicht. Die Schichten 87, 88 weisen ein Emitterfenster 89 auf, in dem ein Emitter 91 vorgesehen ist. Der Emitter 91 befindet sich oberhalb der Basis 86 und ist über entsprechende Spacer-Elemente 90 seitlich gegen die Schichten 87, 88 isoliert.

Der Bipolartransistor 80 weist einen Gesamt-Basiswiderstand auf, der aus drei Einzelkomponenten gebildet ist. Bei der ersten Komponente handelt es sich um den Basiszuleitungswiderstand 95. Die zweite Komponente ist der Basisbahnwiderstand 97. Bei der dritten Widerstandskomponente handelt es sich um den Übergangswiderstand 96, der auch Basisanschlußwiderstand genannt wird. Der Übergangswiderstand 96 liegt in dem Ubergangsbereich zwischen der Basiszuleitung in der dritten Schicht 87 sowie der eigentlichen Basis 86 in der zweiten Schicht 84 vor. Der Übergangswiderstand 96 ist der zu verringernde Anteil des Gesamt-Basiswiderstands und beträgt mindestens 15 % des gesamten Widerstands 95 + 96 + 97.

In Figur 2 ist ein anderer Bipolartransistor 20, wie er aus dem Stand der Technik bekannt ist, in größerem Detail dargestellt. Von diesem Bipolartransistor 20 geht die vorliegende Erfindung aus.

Der Bipolartransistor 20 verfügt zunächst über eine erste, auf einem Substrat 10 befindliche Schicht 30, in der ein Kollektor 31 vorgesehen ist. Bei dem Substrat 10 handelt es sich um ein p-Siliziumsubstrat, das über eine vergrabene Schicht 11, beispielsweise eine n+-Buried-Layer, sowie Kanalstopper 12, beispielsweise p+-Kanalstopper, verfügt.

Der in der ersten Schicht 30 vorgesehene Kollektor 31 kann beispielsweise als n-Kollektor ausgebildet sein, der von Isolationselementen 32, beispielsweise TEOS-Isolationselementen, umgeben ist. Weiterhin weist die erste Schicht 30 einen Kollektorkontakt 33 auf, der über Spacer-Elemente 34 seitlich unter anderem gegen die erste Schicht 30 isoliert ist.

Auf der ersten Schicht 30 ist eine zweite Schicht 40 vorgesehen, die eine Basisaufnehmung 41 zur Aufnahme einer Basis 42 aufweist. Die zweite Schicht 40 kann als TEOS-Schicht ausgebildet sein.

Oberhalb von der zweiten Schicht 40 ist eine dritte Schicht 50 vorgesehen, die aus Polysilizium gebildet sein kann, und die den Basisanschluß bildet. Dazu weist die dritte Schicht 50 entsprechend strukturierte und dotierte Zuleitungen 51 für die Basis 42 auf. Weiterhin ist eine Emitterausnehmung 53 vorgesehen. Oberhalb von der dritten Schicht 50 kann eine weitere Oxidschicht 75, beispielsweise eine TEOS-Schicht und auf dieser Schicht 75 eine weitere Schicht 76, beispielsweise eine Nitridschicht, vorgesehen sein.

Zur Herstellung der Basis 42 wird zunächst die Basisausnehmung 41 hergestellt, beispielsweise durch ein geeignetes Atzverfahren. Anschließend wird in der zweiten Schicht 40 eine Unterätzung 43 hergestellt, deren Ätzfront 44 soweit in die zweite Schicht 40 hineingetrieben wird, daß die Zuleitung 51 in einem Übergangsbereich 52 in direktem Kontakt mit der Unterätzung 43 und später mit der Basis 42 steht. Durch die Unterätzung 53 bildet die dritte Schicht 50 somit einen Überhang. In der Basisausnehmung 41 sowie der wenigstens einen Unterätzung 43 kann nunmehr die Basis 42 hergestellt werden, beispielsweise durch ein Epitaxie-Schichtherstellungsverfahren.

In dem durch die Schichten 50, 75, 76 begrenzten Emitterfenster 60 werden das Emitterfenster seitlich begrenzende Spacer-Elemente 61 erzeugt, die aus Nitrid gebildet sein können und die einen im Emitterfenster 60 erzeugten Emitter seitlich gegen die Schichten 50, 75, 76 isolieren.

Bei der Herstellung des bekannten Bipolartransistors 20 entsteht der Übergangswiderstand (Bezugszeichen 96 in Figur 1) gleichzeitig mit der Herstellung der Basis 42. Der Übergangswiderstand kann damit nicht unabhängig von anderen Herstellungsbedingungen -beispielsweise unabhängig von den Basis-Abscheidebedingungen- eingestellt werden. Eine nachträgliche Wärmebehandlung zur Erniedrigung des Übergangswiderstands ist wegen des begrenzten thermischen Budgets im Basisdotierprofil nur in begrenztem Umfang möglich.

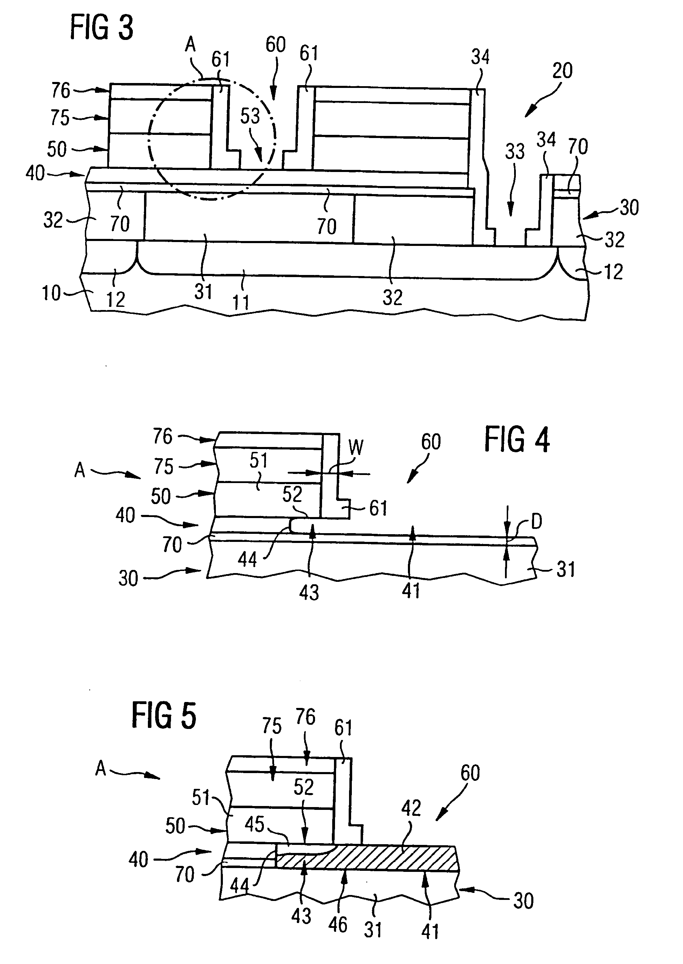

Eine Möglichkeit, wie der Übergangswiderstand und damit der Gesamt-Basiswiderstand bei einem Bipolartransistor, der einen Grundaufbau wie derjenige Bipolartransistor.20 gemäß Figur 2 zeigt, reduziert werden kann, ist im Hinblick auf die Figuren 3 bis 5 gezeigt.

Der in Figur 3 dargestellte Bipolartransistor 20 weist bezüglich seines Substrats 10, der ersten Schicht 30 sowie der weiteren Schichten 40, 50, 75, 76 einen gleichen Aufbau wie der in Figur 2 dargestellte Bipolartransistor auf, so daß zur Vermeidung von Wiederholungen auf eine erneute Beschreibung verzichtet wird.

Der wesentliche Unterschied des in Figur 3 dargestellten Bipolartransistors zu dem in Figur 2 gezeigten Bipolartransistor besteht darin, daß der Bipolartransistor 20 gemäß Figur 3 eine Zwischenschicht 70 aufweist, die zwischen der ersten Schicht 30 und der zweiten Schicht 40 ausgebildet ist. Die Zwischenschicht 70 ist vorteilhaft als Nitridschicht ausgebildet und selektiv auf der ersten Schicht 30 abgeschieden worden. Die Auswahl des Materials für die Zwischenschicht 70 erfolgt in Abhängigkeit zu dem Material der zweiten Schicht 40. Das Material der Zwischenschicht 70 muß so gewählt sein, daß es selektiv zum Material der Schicht 40 ätzbar ist.

Warum dies der Fall ist und wie die Reduzierung des übergangswiderstands erreicht werden kann, wird im Hinblick auf die Figuren 4 und 5 deutlich, bei denen es sich um vergrößerte Ausschnittsansichten des in Figur 3 gezeigten Details A handelt und die verschiedene, nacheinander ablaufende Prozeßschritte bei der Herstellung des Bipolartransistors 20 darstellen.

In Figur 4 ist der Verfahrensschritt dargestellt, in dem in der Schicht 40 eine Unterätzung 43 erzeugt wird. Die Unterätzung 43 wird mit ihrer Ätzfront 44 soweit in die Schicht 40 hineingetrieben, daß die Schicht 50 sowie die darauf befindlichen Schichten 75, 76 einen Überhang bilden. Die Zuleitung 50 wird auf ihrer Unterseite soweit freigelegt, daß ein Übergangsbereich 52 entsteht, mit dem die Zuleitung 50 in direktem Kontakt mit der Unterätzung 43 steht.

Da die als Nitridschicht ausgebildete Zwischenschicht 70 selektiv ätzbar zur vorzugsweise als TEOS-Schicht ausgebildeten zweiten Schicht 40 ist, wird diese während der Unterätzung der TEOS-Schicht 40 nicht entfernt. Es ist nun möglich, vor Erzeugung der Basis 42 den Übergangswiderstand (Bezugszeichen 96 in Figur 1) gezielt zu verringern. Dies ist im Detail in Figur 5 dargestellt.

Nach Fertigstellung der Unterätzung 43 ist es nun möglich, unter selektiven Abscheidebedingungen, und bei erhöhten Temperaturen von beispielsweise mehr als 800 °C einen Basisanschlußbereich 45 herzustellen. Dieser Basisanschlußbereich 45, der aus Polysilizium gebildet und ein p+-Anschluß sein kann, wird erzeugt, indem er unter dem Überhang, das heißt im Bereich der Unterätzung 43, "herausgewachsen" wird. Das Wachstum des Basisanschlußbereichs 45 kann unabhängig von anderen Herstellungsbedingungen, beispielsweise den in Figur 2 beschriebenen Basisabschiedebedingungen, eingestellt werden. So kann beim Wachstum des Basisanschlußbereichs 45 beispielsweise die Temperatur und die Dotierung gezielt eingestellt, beispielsweise erhöht werden. Während des Abscheidevorgangs wächst der Basisanschlußbereich 45 auf dem Übergangsbereich 52 auf und in den Bereich der Unterätzung 43 hinein. Die Abscheidebedingungen werden hierbei so gewählt, daß auf der Zwischenschicht 70 kein Basisanschlußbereich 45 entsteht.

Nach Fertigstellung des Basisanschlußbereichs 45 wird die Zwischenschicht 70 im Kontaktbereich 46, das heißt in dem Bereich der Basisausnehmung 41 sowie dem Bereich der Unterätzung 43, in dem kein Basisanschlußbereich 45 gebildet wurde, wodurch ein Hohlraum zwischen Basisanschlußbereich 45 und der Zwischenschicht 70 bestehen blieb, entfernt werden. Die Entfernung der Zwischenschicht 70 kann selektiv zur zweiten Schicht 40 mit Phosphorsäure erfolgen. Danach wird die selektive Basisabscheidung durchgeführt. Der Vorteil dieses Vorgehens besteht darin, daß der Basisanschlußbereich 45 unabhängig von den Basis-Abscheidebedingungen eingestellt werden kann.

Die Dicke D der Zwischenschicht 70 sollte derart gewählt werden, daß sie zwischen 4 nm und der Hälfte der Breite W des Spacer-Elements 61 liegt.

## Patentansprüche

1. Verfahren zum Herstellen eines Bipolartransistors, mit folgenden Schritten:
a) auf einem Substrat (10) wird eine erste Schicht (30) erzeugt, in der ein Kollektor (31) gebildet wird;
b) auf der ersten Schicht (30) wird eine Zwischenschicht (70) aufgebracht;
c) auf der Zwischenschicht (70) wird eine zweite Schicht (40) aufgebracht, wobei die Zwischenschicht (70) aus einem Material besteht, das selektiv ätzbar zum Material der zweiten Schicht (40) ist;
d) auf der zweiten Schicht (40) wird eine dritte Schicht (50) gebildet, die so ausgestaltet wird, daß sie eine Zuleitung (51) für eine Basis (42) bildet;
e) die zweite (40) und dritte (50) Schicht wird derart bearbeitet, daß in der zweiten Schicht (40) eine Basisausnehmung (41) für eine Basis (42) und in der dritten Schicht (50) eine Emitterausnehmung (53) für einen Emitter erzeugt wird, wobei die Basisausnehmung (41) oberhalb des Kollektors (31) und die Emitterausnehmung (53) oberhalb der Basisausnehmung (41) ausgebildet wird;
f) in der zweiten Schicht (40) wird im Anschluß an die Basisausnehmung (41) zwischen erster (30) und dritter (50) Schicht eine Unterätzung (43) gebildet, wobei die Zwischenschicht (70) auf Grund ihres zur zweiten Schicht (40) selektiv ätzbaren Materials nicht entfernt wird;
g) in einem zwischen der Zuleitung (51) und der Unterätzung (43) entstehenden Übergangsbereich (52) wird ein mit der Zuleitung (51) in Kontakt stehender Basisanschlußbereich (45) erzeugt, der teilweise die Unterätzung (43) ausfüllt, wobei der Basisanschlußbereich (45) derart erzeugt wird, daß die Zwischenschicht (70) nicht mit Basisanschlußbereichs-Material bedeckt ist;
h) derjenige Kontaktbereich (46) der Zwischenschicht (70), der in der Unterätzung (43) nicht mit Material des Basisanschlußbereichs (45) bedeckt ist und der mit der Basisausnehmung (41) in direktem Kontakt steht, wird entfernt;
i) in der Basisausnehmung (41) sowie demjenigen Bereich der Unterätzung (43), der nicht mit Material des Basisanschlußbereichs (45) ausgefüllt ist, wird eine Basis (42) gebildet;
j) oberhalb der Basis (42) wird ein Emitter gebildet.

2. Verfahren nach Anspruch 1,
**dadurch gekennzeichnet,**
**daß** der Basisanschlußbereich (45) selektiv abgeschieden wird.

3. Verfahren nach Anspruch.1 oder 2,
**dadurch gekennzeichnet,**
**daß** der Basisanschlußbereich (45) im Übergangsbereich (52) zwischen der Zuleitung (51) und der Basis (42) in der Unterätzung (43) "herausgewachsen" wird.

4. Verfahren nach einem der Ansprüche 1 bis 3,
**dadurch gekennzeichnet,**
**daß** der Basisanschlußbereich (45) unabhängig von den Bedingungen zur Herstellung der Basis (42) erzeugt wird.

5. Verfahren nach einem der Ansprüche 1 bis 4,
**dadurch gekennzeichnet,**
**daß** der Basisanschlußbereich (45) bei erhöhten Temperaturen von größer/gleich 800 °C erzeugt wird.

6. Verfahren nach einem der Ansprüche 1 bis 5,
**dadurch gekennzeichnet,**
**daß** die Dotierung des Basisanschlußbereichs (45) frei und unabhängig von der aktiven Basis eingestellt wird oder werden kann.

7. Verfahren nach einem der Ansprüche 1 bis 6,
**dadurch gekennzeichnet,**
**daß** die Zwischenschicht (70) aus Nitrid gebildet wird und daß die Zwischenschicht (70) bereichsweise gemäß Schritt h) in Anspruch 11 mittels Phosphorsäure entfernt wird.

8. Verfahren nach einem der Ansprüche 1 bis 7,
**dadurch gekennzeichnet,**
**daß** in der Emitterausnehmung (53) wenigstens ein Spacer-Element (61) ausgebildet wird.

9. Verfahren nach einem der Ansprüche 1 bis 8,
**dadurch gekennzeichnet,**
**daß** die Zwischenschicht (70) mit einer Dicke (D) von gröβer/gleich 4nm und kleiner/gleich der halben Breite (W) des Spacer-Elements (61) gebildet wird.

## Claims

1. Method for fabricating a bipolar transistor, having the following steps:
a) a first layer (30) is produced on a substrate (10), in which layer a collector (31) is formed;
b) an intermediate layer (70) is applied on the first layer (30);
c) a second layer (40) is applied on the intermediate layer (70), the intermediate layer (70) being composed of a material which can be etched selectively with respect to the material of the second layer (40);
d) a third layer (50) is formed on the second layer (40), which third layer is configured in such a way that it forms a lead (51) for a base (42);
e) the second (40) and third (50) layer is processed in such a way that a base cutout (41) for a base (42) is produced in the second layer (40) and an emitter cutout (53) for an emitter is produced in the third layer (50), the base cutout (41) being formed above the collector (31) and the emitter cutout (53) being formed above the base cutout (41);
f) an undercut (43) is formed in the second layer (40) in a manner adjoining the base cutout (41) between first (30) and third (50) layer, the intermediate layer (70) not being removed on account of its material which can be etched selectively with respect to the second layer (40);
g) a base terminal region (45) in contact with the lead (51) is produced in a transition region (52) produced between the lead (51) and the undercut (43), which base terminal region partly fills the undercut (43), the base terminal region (45) being produced in such a way that the intermediate layer (70) is not covered with base terminal region material;
h) that contact region (46) of the intermediate layer (70) which, in the undercut (43), is not covered with material of the base terminal region (45) and which is in direct contact with the base cutout (41) is removed;
i) a base (42) is formed in the base cutout (41) and that region of the undercut (43) which is not filled with material of the base terminal region (45);
j) an emitter is formed above the base (42).

2. Method according to Claim 1,
**characterized**
**in that** the base terminal region (45) is deposited selectively.

3. Method according to Claim 1 or 2,
**characterized**
**in that** the base terminal region (45) is "grown out" in the transition region (52) between the lead (51) and the base (42) in the undercut (43).

4. Method according to one of Claims 1 to 3,
**characterized**
**in that** the base terminal region (45) is produced independently of the conditions for fabricating the base (42).

5. Method according to one of Claims 1 to 4,
**characterized**
**in that** the base terminal region (45) is produced at elevated temperatures of greater than/equal to 800°C.

6. Method according to one of Claims 1 to 5,
**characterized**
**in that** the doping of the base terminal region (45) is or can be set freely and independently of the active base.

7. Method according to one of Claims 1 to 6,
**characterized**
**in that** the intermediate layer (70) is formed from nitride, and in that the intermediate layer (70) is removed in regions in accordance with step h) in Claim 1 by means of phosphoric acid.

8. Method according to one of Claims 1 to 7,
**characterized**
**in that** at least one spacer element (61) is formed in the emitter cutout (53).

9. Method according to one of Claims 1 to 8,
**characterized**
**in that** the intermediate layer (70) is formed with a thickness (D) of greater than/equal to 4 nm and less than/equal to half the width (W) of the spacer element (61).

## Revendications

1. Procédé de fabrication d'un transistor bipolaire, comprenant les stade :
a) on produit sur un substrat (10) une première couche (30), dans laquelle le collecteur (31) est formé ;
b) on dépose une couche (70) intermédiaire sur la première couche (30) ;
c) on dépose une deuxième couche (40) sur la couche (70) intermédiaire, la couche (70) intermédiaire étant en un matériau qui peut être attaqué sélectivement par rapport au matériau de la deuxième couche (40) ;
d) on forme sur la deuxième (40), une troisième couche (50), qui est telle qu'elle forme une entrée (51) pour une base (42) ;
e) on traite la deuxième (40) et la troisième (50) couches, de manière à produire dans la deuxième couche (30) un évidement (41) pour une base (42) et dans la troisième couche (50), un évidement (53) pour un émetteur, l'évidement (41) pour une base étant formé au-dessus du collecteur (31) et l'évidement (53) pour un émetteur étant formé au-dessus de l'évidement (41) pour une base ;
f) on forme une attaque (43) en retour dans la deuxième couche (40) à la suite de l'évidement (41) pour une base entre la première (30) et la troisième (50) couches, la couche (70) intermédiaire n'étant pas éliminée en raison de son matériau pouvant être attaqué sélectivement par rapport à la deuxième couche (40) ;
g) on produit dans une zone (52) de transition se créant entre l'entrée (50) et l'attaque (43) en retrait une zone (45) de connexion de base en contact avec l'entrée (51) et remplissant en partie l'attaque (43) en retrait, la zone (45) de connexion de base étant produite de manière à ce que la couche (70) intermédiaire ne soit pas recouverte du matériau de la zone de connexion de base ;
h) on élimine la zone (46) de contact de la couche (70) intermédiaire, qui, dans l'attaque (43) en retrait, n'est pas recouverte de matériau de la zone (45) de connexion de base et qui est en contact direct avec l'évidement (41) pour une base ;
i) on forme une base (42) dans l'évidement (41) pour une base, ainsi que dans la zone de l'attaque (43) en retrait, qui n'est pas remplie de matériau de la zone (45) de connexion d'une base ;
j) on forme un émetteur au-dessus de la base (42).

2. Procédé suivant la revendication 1,
**caractérisé**
**en ce que** l'on dépose sélectivement la zone (45) de connexion de base.

3. Procédé suivant la revendication 1 ou 2,
**caractérisé**
**en ce que** on "élimine par lavage" la zone (45) de connexion de base dans la zone (52) de transition entre l'entrée (51) et la base (42) dans l'attaque (43) en retrait.

4. Procédé suivant l'une des revendications 1 à 3,
**caractérisé**
**en ce que** l'on produit la zone (45) de connexion de base indépendamment des conditions de fabrication de la base (42).

5. Procédé suivant l'une des revendications 1 à 4,
**caractérisé**
**en ce qu'**on produit la zone (45) de connexion de base à des températures élevées supérieures ou égales à 800°C.

6. Procédé suivant l'une des revendications 1 à 5,
**caractérisé**
**en ce que** l'on règle ou on peut régler le dopage de la zone (45) de connexion de base librement et indépendamment de la base active.

7. Procédé suivant l'une des revendications 1 à 6,
**caractérisé**
**en ce qu'**on forme la couche (70) intermédiaire en nitrure et en ce que l'on élimine la couche (70) intermédiaire par zone suivant le stade h) à la revendication 1 au moyen d'acide phosphorique.

8. Procédé suivant l'une des revendications 1 à 7,
**caractérisé**
**en ce que** l'on forme au moins un élément (61) d'espaceur dans l'évidement (53) pour un émetteur.

9. Procédé suivant l'une des revendications 1 à 8,
**caractérisé**
**en ce que** l'on donne à la couche (70) intermédiaire une épaisseur (D) supérieure ou égale à 4nm et inférieure ou égale à la moitié de l'épaisseur (W) de l'élément (61) d'espaceur.
